(19) Europäisches Patentamt
European Patent Office
Office européen des brevets

(11) **EP 1 011 193 A1**

(12) **EUROPEAN PATENT APPLICATION**

(43) Date of publication:
**21.06.2000 Bulletin 2000/25**

(51) Int. Cl.[7]: **H03F 3/08**

(21) Application number: **98830741.9**

(22) Date of filing: **09.12.1998**

(84) Designated Contracting States:
**AT BE CH CY DE DK ES FI FR GB GR IE IT LI LU MC NL PT SE**
Designated Extension States:
**AL LT LV MK RO SI**

(71) Applicant:
**STMicroelectronics S.r.l.**
**20041 Agrate Brianza (Milano) (IT)**

(72) Inventor: **Bianchi, Massimo**
**20017 Rho (IT)**

(74) Representative:
**Pellegri, Alberto et al**
**c/o Società Italiana Brevetti S.p.A.**
**Piazza Repubblica, 5**
**21100 Varese (IT)**

(54) **Amplified photoelectric detector**

(57)     Performances of an amplified photodetector comprising a photodetecting diode and a transimpedance amplifier stage, are enhanced by providing it with a unit gain current buffer stage decoupling the parasitic capacity of said photodiode from the input node of said transimpedance amplifier.

FIG. 2

**Description**

FIELD OF THE INVENTION

The present invention relates to photoelectric transducers and more in particular to read circuits of an integrated photodetector.

BACKGROUND OF THE INVENTION

In the field of data acquisition, reading of optical disks, of optical signals receivers, typically in the visible and infrared spectrum, photodetectors are commonly integrated in devices containing amplifying circuits, circuits for the eventual regeneration of the digital signals and de-coding circuits.

The photodetector is commonly an inversely biased junction diode whose junction region is illuminated by the optical signal. The photogenerated current of the diode represents the electric signal that must be firstly amplified before proceeding to its further processing.

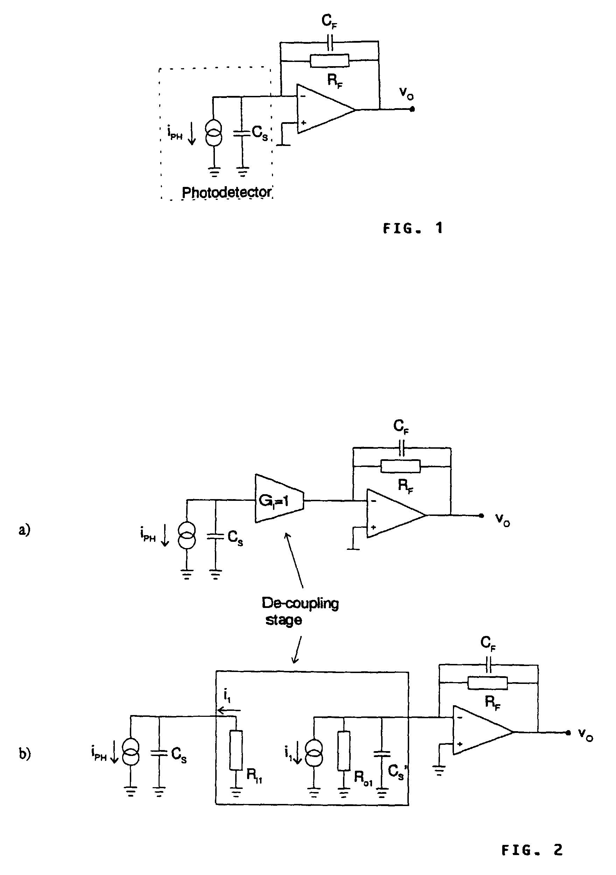

Fig. 1 shows the scheme of a typical amplified photodetector.

$i_{PH}$ represents the photogenerated current source of the photodetector, $C_S$ is the parasitic capacitance associated to the inverse biased junction of the photodiode whose value may also comprise the capacitance of the input node of the operational amplifier OP.

The operational amplifier has a classical transimpedance configuration.

The feedback resistor $R_F$ is the component that converts the current photogenerated by the photodiode in an output voltage $V_O$. The capacitor $C_F$, commonly connected in parallel to the resistor $R_F$ in the feedback loop, is introduced for stability reasons.

In systems designed for operating at increasingly higher frequencies comprising photodetecting stages, stability and speed requisites became increasingly more difficult to fulfill with technological refinements of the process of fabrication of the integrated photodiode and of the read circuitry of the photogenerated current signal.

OBJECT AND SUMMARY OF THE INVENTION

Object of the invention is to provide for an amplified photodetector device with improved characteristics of speed and stability or the same fabrication technology.

According to the present invention, for the same physical characteristics and electrical properties of the integrated photodiode, this important result is achieved by introducing a buffer stage of unitary current gain for decoupling of the parasitic capacitance of the photodiode from the input of the transimpedance operational amplifier.

The decoupling current buffer may be realized with a bipolar junction transistor in a common base configuration. The current photogenerated by the photodiode is injected on the emitter node of the transistor and a buffered replica of it is made available on the collector node of the transistor (output), while allowing for a precise dissipation towards ground of the bias current imposed through the bipolar junction transistor. The voltage of operation of the transistor is fixed by a differential stage and both the differential stage and the transistor are biased by way of current mirrors mirroring the current generated by a unique bias generator of the entire buffer circuit.

The output of the current buffer is coupled to the input of a common transimpedance operational amplifier seeing an input capacitance that corresponds to the value of the output capacitance of the buffer stage, much lower than the capacitance associated to the reverse biased junction of the photodiode.

BRIEF DESCRIPTION OF THE DRAWINGS

The different aspects and advantages of the invention will become even more evident through the following description of an embodiment and by referring to the drawings in which:

**Figure 1**, as already discussed above, is a typical scheme of an amplified photodetector;

**Figures 2a** and **2b** show the scheme of an amplified photodetector realized according to the present invention the corresponding small signal equivalent circuit of the decoupling stage, respectively;

**Figure 3** is a Bode diagram comparison of the circuit characteristics of a known circuit (phantom line) with the characteristics of the circuit of the invention (solid line);

**Figure 4** shows a possible circuit embodiment of the buffer stage of the amplified photodetector device of the invention.

## DESCRIPTION OF AN EMBODIMENT OF THE INVENTION

By referring to Figures 2a and 2b, the circuit current gain ($G_I = 1$) buffer stage acts as an impedance decoupler by presenting a low parasitic capacitance $C'_S$ at the input of the transimpedance amplifier, much lower than the parasitic capacitance $C_S$ of a photodiode.

As it will be demonstrated in the ensuing description, this determines an outstanding improvement of the frequency response of the read circuit of the photodiode with an appreciable increment of the bandwidth.

The transfer function of the known circuit of Fig. 1 may be written as:

$$V_O = i_{PH} \frac{Z_F}{1 + \dfrac{1}{G_{loop}}} \qquad (1)$$

wherein:

$$G_{loop} = A(s)\beta(s) = \frac{A(s)}{1 + sC_s Z_F(s)}$$

where $Z_F(s)$ is equivalent to the "parallel" between the two impedances, symbolically: $Z_F(s) = R_F \parallel (1/sC_F)$, $A(s)$ is the open loop gain of the operational amplifier and $\beta(s)$ indicates the feedback factor, equal to the reciprocal of the noninverting signal gain.

As far as $G_{loop} \gg 1$ is concerned, the term $Z_F(s)$ establishes the signal transfer function with a transresistance gain set by $R_F$ and a pole set by the time constant $R_F C_F$ which must be maintained outside the useful bandwidth.

However, when $A(s)$ and $1/\beta(s)$ become equal in amplitude, the loop gain decreases to 1, the inverting input of the operational amplifier ceases to functions as a virtual ground and the close loop bandwidth begins to roll off.

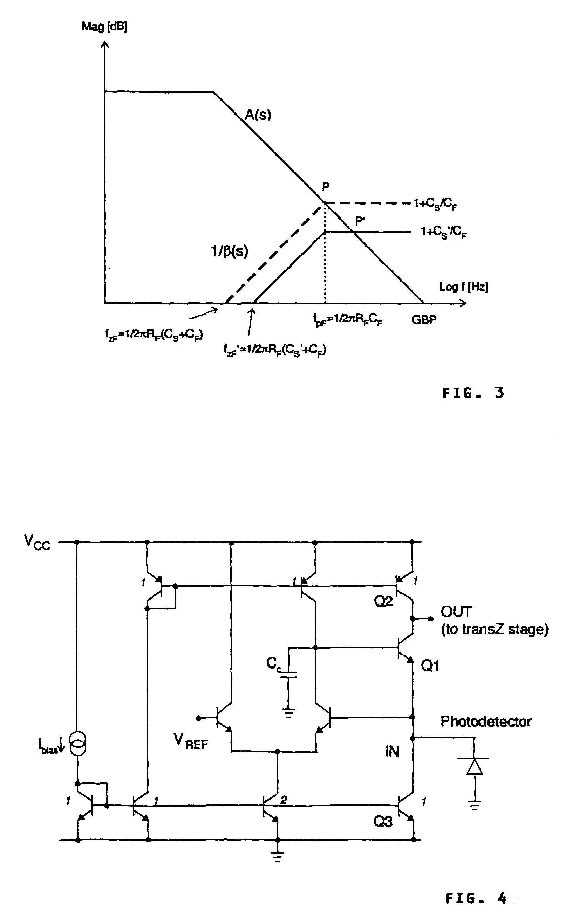

These considerations may be visualized in Fig. 3 which shows the Bode diagram of the open loop gain $A(s)$ (assuming a single pole approximation) and with the phantom line the noninverting signal gain $1/\beta(s)$, being the complete expression of this second term as follows:

$$\frac{1}{\beta(s)} = 1 + sC_s Z_F(s) = \frac{1 + sR_F(C_S + C_F)}{1 + sR_F C_F}$$

The above equation reveals the presence of two singularities:
the established pole:

$$f_{pF} = \frac{1}{2\pi R_F C_F} \qquad (2)$$

and the zero

$$f_{zF} = \frac{1}{2\pi R_F (C_s + C_F)} \qquad (3)$$

Since the transfer function from $i_{PH}$ to $V_O$ given by equation 1 includes a pole due to $Z_F$, it is not possible to directly predict the close loop frequency response from the Bode diagrams of Fig. 3.

However, from the preceding considerations, it may be observed that, for obtaining a relatively broad close loop bandwidth, the frequency at which $G_{loop}$ drops to 1, that is at the intersection point P of $A(s)$ and $1/\beta(s)$, be as high as possible, so that the close loop transimpedance gain begins to decrease outside the specified useful bandwidth.

Often, this is not the case in integrated circuits. In other words, the configuration of Fig. 1 has an intrinsic bandwidth limitation because the frequency at which $G_{loop}$ decreases to 1 is too low, especially if the application requires a high transresistance gain (a large $R_F$ typically in the range of several Kiloohms) and photodiodes with a relatively large area (having a parasitic capacitance $C_S$ of several picofarads).

The problem of shifting the intersection point P to the highest frequency as possible becomes, according to the present invention, that of reducing the source capacitance $C_C$ seen by the transimpedance amplifying stage, in consideration that A(s) is practically fixed (the use of an operational amplifier with a gain bandwidth product as large as possible being a natural design choice), $R_F$ is imposed by the required transresistance gain and $C_F$ is imposed by the need to guarantee frequency stability with an adequate phase margin (in the example illustrated in Fig. 3, $C_F$ is chosen such that the feedback pole $f_{pF}$ is placed exactly at the intersection point P, coinciding with a phase margin of 45°).

According to the invention, this result is obtained by introducing a decoupling stage as illustrated in Figures 2a and 2b, wherein $C_S' < C_S$.

The output resistance $R_{o1}$ of the current buffer most preferably has a very large value so that it can be neglected.

As far as the functioning conditions of the transimpedance amplifier are concerned, they are exactly the same as those existing in the known circuit of Fig. 1 with the only exception that the output parasitic capacitance $C_S'$ of the buffer stage that is introduced substitutes in the analysis of operation the parasitic capacitance $C_S$ of the photodiode.

By observing the $1/\beta(s)$ solid line characteristic of Fig. 3, the only difference from the characteristic of the known circuit that is introduced is the position of the zero at the frequency given by:

$$f_{zF}' = \frac{1}{2\pi R_F(C_S' + C_F)}$$

instead of at the frequency given by equation (3), and that the high frequency gain $1/(C_S' + C_F)$, is now smaller, the feedback pole still being given by equation (2).

As it may be observed from the diagrams of Fig. 3, the intersection point P between the characteristics A(s) and $1/\beta(s)$ shifts to the position P', that is, the frequency where the loop gain decreases to 1 becomes higher and as a consequence the close loop bandwidth increases. Moreover also the phase margin increases and frequency stability is improved.

On the other hand, the capacitance $C_S$ of the photodiode generates a high frequency nondominating pole, provided that the input resistor $R_{i1}$ of the decoupling stage has a relatively low value.

Fig. 4 shows an example of circuital implementation of the impedance decoupling stage of the amplifier photoelectric transducer of the invention.

The principal element is the transistor Q1 which can be considered as a common-base stage.

The input current signal, originating from the photodiode, in injected on the emitter node of the transistor Q1 and a buffered replica of this input current is made available on the output node, considering that the bias current of the common base stage imposed by the transistor Q2 is completely dissipated to ground through the transistor Q3.

The input resistance seen by the current signal is strongly decreased by the negative feedback.

In practice, the circuit may be considered as an operational amplifier with full feedback (that is in a unit gain buffer configuration) having a very low output resistance.

$C_C$ is the loop compensation capacitor.

The negative feedback cause a very high output resistance. In other words, the feedback action permits to ensure a very low input resistance, $R_{i1}$, and very high output resistance, $R_{o1}$, according to the equivalent circuit of Fig. 2b.

It should be noticed that the output node capacitance of the circuit $C'_S$ is much lower than the parasitic capacitance $C'_S$ associated to a photodiode, especially if the photodiode area is rather large, because of application requirements.

In terms of orders of magnitude, in a wholly integrated embodiment of the circuit and of the photodiode a value of capacitance of the output node of the buffer stage: $C'_S \approx 0.5pF$ has been obtained. This is well below the value of about 1.5pF of the parasitic capacitance $C_S$ of a photodiode having an area of $0.02mm^2$ ($30mils^2$) or of 12pF in case of an area of $0.2mm^2$ ($300mils^2$).

**Claims**

1. An amplified photodetector comprising a photodetecting diode and a transimpedance amplifier stage, characterized in that comprises a unit gain current buffer stage decoupling the parasitic capacity of said photodiode from the input node of said transimpedance amplifier.

2. The amplified photodetector according to claim 1, characterized in that said unit gain current buffer stage is composed of

an output stage (Q1) constituted by a bipolar junction transistor in a common-base configuration, having injected on the emitter node the photogenerated current of said photodiode and coupled thereto to the inverting input of a differential stage controlling the voltage of operation of said common-base output stage;

complementary current mirrors biasing said differential stage and said output stage with a bias current generated by a unique current generator;

a compensation capacitor ($C_C$) connected between the driving node of said common-base output stage (Q1) and ground.

FIG. 1

FIG. 2

Mag [dB]

A(s)

P

$1+C_S/C_F$

P'

$1+C_S'/C_F$

$1/\beta(s)$

Log f [Hz]

$f_{zF}=1/2\pi R_F(C_S+C_F)$

$f_{zF}'=1/2\pi R_F(C_S'+C_F)$

$f_{pF}=1/2\pi R_F C_F$

GBP

**FIG. 3**

$V_{CC}$

1

1

Q2

OUT
(to transZ stage)

$C_c$

Q1

$I_{bias}$

$V_{REF}$

Photodetector

IN

1

1

1

2

1

Q3

**FIG. 4**

European Patent
Office

**EUROPEAN SEARCH REPORT**

Application Number

EP 98 83 0741

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 304 949 A (CHUN CHRISTOPHER K Y) 19 April 1994 (1994-04-19) | 1 | H03F3/08 |
| Y | * the whole document * | 2 | |
| Y | US 5 126 568 A (DURST DAVID I) 30 June 1992 (1992-06-30) * column 5, line 1 - line 50; figure 2 * | 2 | |
| A | US 5 281 925 A (HULICK TIMOTHY P) 25 January 1994 (1994-01-25) * column 4, line 47 - column 6, line 35; figure 4 * | 2 | |
| A | DE 26 43 892 A (SIEMENS AG) 30 March 1978 (1978-03-30) * page 5, line 31 - page 6, line 10; figure 2 * | 2 | |

| | TECHNICAL FIELDS SEARCHED (Int.Cl.7) |
|---|---|
| | H03F |

The present search report has been drawn up for all claims

| Place of search | Date of completion of the search | Examiner |
|---|---|---|
| THE HAGUE | 1 October 1999 | Tyberghien, G |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**                    EP 98 83 0741

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-1999

| Patent document cited in search report | | Publication date | Patent family member(s) | Publication date |
|---|---|---|---|---|
| US 5304949 | A | 19-04-1994 | NONE | |
| US 5126568 | A | 30-06-1992 | NONE | |
| US 5281925 | A | 25-01-1994 | NONE | |
| DE 2643892 | A | 30-03-1978 | NONE | |